# EUROPEAN PATENT SPECIFICATION

(11) **EP 0 621 645 B1**
(45) Date of publication and mention of the grant of the patent: **19.06.2002**
(21) Application number: 94302523.9
(22) Date of filing: 11.04.1994
(51) Int. Cl.: H01L 31/09, G02F 1/135

(54) **Optical switching element and optical scanning display using it**
Optisches Schaltelement und optische adressierte Anzeige unter Verwendung desselbe
Elément de commutation optique et dispositif d'affichage à balayage optique l'utilisant

(30) Priority: 19.04.1993 JP 9131193
(43) Date of publication of application: 26.10.1994
(73) Proprietor: SHARP KABUSHIKI KAISHA, Osaka-shi, Osaka-fu 545-0013 (JP)
(72) Inventor: Izumi, Yoshihiro, Kashihara-shi, Nara-ken (JP)
(74) Representative: Suckling, Andrew Michael

(56) References cited:
- EP-A- 0 309 000
- EP-A- 0 490 484
- EP-A- 0 552 993
- WO-A-91/07689
- US-A- 4 743 750
- PATENT ABSTRACTS OF JAPAN vol. 12, no. 150 (E-606) & JP-A-62 264 676 (TOSHIBA)
- PATENT ABSTRACTS OF JAPAN vol. 13, no. 543 (P-970) & JP-A-01 224 727 (CASIO)
- PATENT ABSTRACTS OF JAPAN vol. 17, no. 194 (P-1522) & JP-A-04 340 932 (SEIKO EPSON)

## Description

The present invention relates to an optical scanning display using an optical switching element which can control an electric signal by light and which can be applied to various devices using optical signals in the fields of optical communications, information processing, etc. An optical scanning display of the present invention can be utilized in the fields of AV (audiovisual) devices and equipments such as televisions or games, OA (office automation) devices and equipments such as personal computers or word processors, and optical information processing as optical modulator or as optical operator.

It is general that wiring resistance and stray capacitance cause a delay in signal waveform when a drive signal is transmitted through electric lines. To solve these issues, a desired display is of an optical scanning type, which transmits a drive signal with light.

Fig. 10 is a plan view to show the structure of an optical scanning active-matrix liquid crystal display as described in Japanese Patent Application No. 3-263947 filed by the present applicant prior to this application.

Fig. 11 is a cross section of an element as seen along G-G' line in Fig. 10.

There are a plurality of optical waveguides Y₁, Y₂,..., Yₙ aligned in the vertical direction on one of substrates constituting a liquid crystal panel. Also, a plurality of signal electrodes X₁, X₂,..., Xₘ are arranged above the waveguides in the horizontal direction as intersecting with the optical waveguides. A switching element 4 of photoconductor is provided at an intersection between an optical waveguide Yₙ and a signal electrode Xₘ, which is controlled by an optical signal transmitted from a light-emitting element array 10 through the optical waveguide Yₙ. The optical switching element 4 has a low impedance upon light irradiation, whereby the signal electrode Xₘ is electrically connected with a picture element (pixel) electrode 5. In contrast, the optical switching element 4 has a high impedance with no light irradiation, so that the signal electrode Xₘ and the pixel electrode 5 are kept in an electrically insulated state. Namely, the above display is an optical scanning display which drives a liquid crystal 13 of electrooptic medium by utilizing the impedance change of optical switching element 4 with light being used as scanning signal.

The display needs a back light such as a fluorescent lamp in the use as transmission display or a projection lamp such as a metal halide lamp in the use as projection display. Projected light is modulated in the panel so as to enable indication. If the pixel electrodes 5 are formed as reflecting electrodes, the display can be used as reflection display needing no back light.

Optical switching elements 4 are roughly classified by construction under the following two groups.
(1) Lamination structure of source electrode/photoconductor/drain electrode (or drain electrode/photoconductor/source electrode)
(2) Planar structure in which a source electrode and a drain electrode both are formed on one side of photoconductor

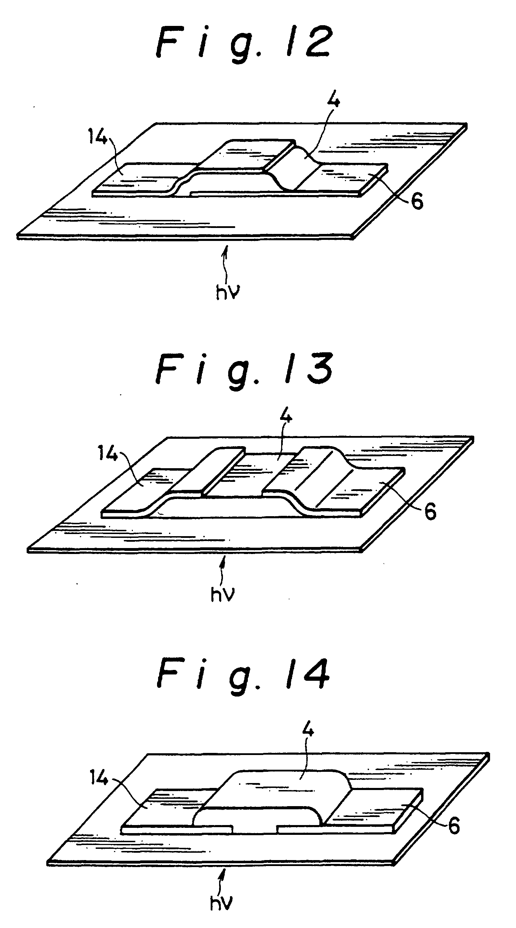

Fig. 12 and Fig. 13 are schemes of optical switching elements with the above structures, which are often used for photodetectors, for example.

In the above two structures, it is preferred that the source electrode and the drain electrode are made of a common electrode material, considering the symmetry of switching property to the polarity of applied voltage. However, in case of the lamination structure of Fig. 12, an electrode on the light-irradiated side of element (which is the drain electrode in Fig. 12), must be a transparent electrode or a translucent metal film, which limits electrode materials which can be used. Also, since attenuation of light occurs due to absorption in photoconductor, the number of carriers produced on the source electrode side is different from that on the drain electrode side, causing asymmetry of switching property. Therefore, the planar structure of Fig. 13 is suitable for optical switching elements, because it has no restriction on electrode materials to be employed, and the irradiation conditions are equal on the source electrode side and the drain electrode side so as to produce the same number of carriers on the both electrode sides.

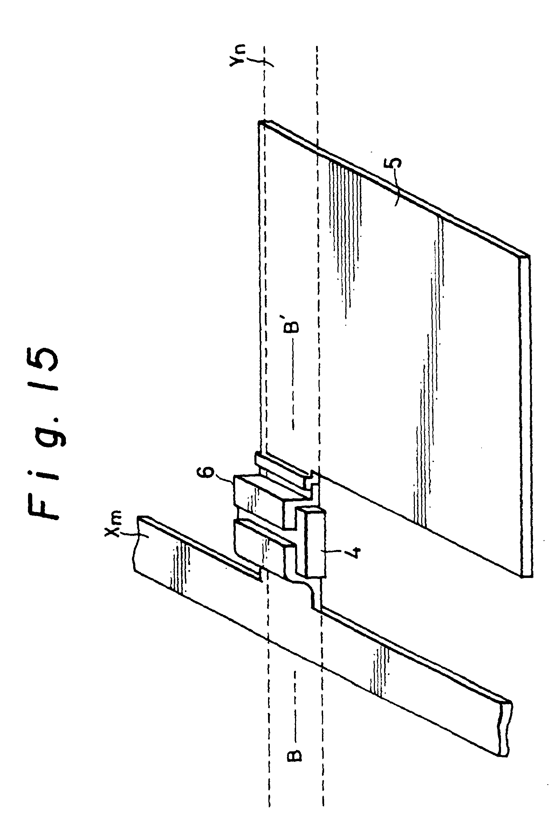

For example, Fig. 15 is a perspective view to show an arrangement in the vicinity of an optical switching element in a conventional display, which is an example using the optical switching element of the planar structure as shown in Fig. 13.

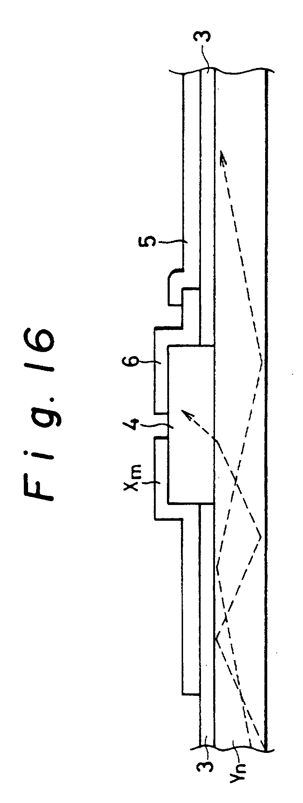

Fig. 16 is a drawing to show the structure of element as seen along B-B' line in Fig. 15, which shows the detailed structure of the source electrode and the drain electrode. In this arrangement, a signal electrode Xₘ functions as a source electrode, which is a film formed of a metal such as aluminum, titanium or molybdenum. Also, the drain electrode 6 is formed as a film of the same metal as the source electrode (signal electrode Xₘ).

Meanwhile, it is of course possible that the optical switching element of such planar structure may be constructed in such a structure that the source electrode and the drain electrode are located underneath the photoconductor, that is, on the light-irradiated side (Fig. 14), other than the structure as shown in Fig. 13. For example, the active-matrix panel as described in Japanese Patent Application Laying Open (KOKAI) No. 1-224727 (CASIO COMPUTER CO., LTD.) employs the structure of Fig. 14 for optical switching element.

The optical switching elements of the planar structures as shown in Fig. 13 and Fig. 14 as described above, however, had the following problems.

First in case of the element structure of Fig. 13, if amorphous hydrogenated silicon (a-Si:H) is used as a photoconductor material, an appropriate film thickness of photoconductor is in the range of 5000 angstroms to 1 µm in respect of absorption efficiency of light. which produces a considerable step at the edge of photoconductor. This could cause a disconnection problem of a source electrode or a drain electrode set on the step. Particularly, if a photoconductor is patterned by dry etching, the shape of edge becomes so acute as to cause disconnection easily.

In the case of the element structure of Fig. 14, if the source electrode and the drain electrode are made of a metal material, an optical signal cannot impinge on the photoconductor in electrode portions, and the irradiation is limited to a small space excluding the electrode portions. Accordingly, the effective irradiation area is decreased so as to reduce the total number of photoproduction carriers. This results in failing to efficiently achieve the impedance change between the electrodes with irradiation of optical signal.

In case the optical switching element is used in an optical scanning display, the following problems could occur in addition.

An optical switching element used in optical scanning display must have a large impedance change with light irradiation and, at the same time, an ON-state current large enough to charge an electrooptic medium such as liquid crystal upon irradiation. As for this point, if there is a limit in increasing the light irradiation amount, the requirement can be satisfied generally by increasing a ratio w/l (w: electrode width, 1: electrode gap) of optical switching element. Nevertheless, increasing the ratio w/l of optical switching element increases the total area of optical switching element, which decreases the occupying rate of pixel area in display, or decreases the aperture rate. The increase in w/l increases the OFF-state current as well, so that a great impedance change cannot be expected.

Also, the two substrates constituting the display each needed a shielding film in order to prevent light other than the optical signal necessary for drive from impinging on the optical switching element, which was another factor to decrease the aperture rate of display.

EP-A-0 490 484 discloses an optical scanning display according to the preamble of claim 1 and a method of manufacturing an optical scanning display according to the preamble of claim 7.

In one embodiment of EP-A-0 490 484 the optical scanning display is provided with a single light shield, which is disposed outside the liquid crystal device (on the upper face of the upper substrate of the display). In an alternative embodiment, the display is further provided with a second light shield, which is also disposed outside the liquid crystal cell (on the lower face of the lower substrate). In a further embodiment of EP-A-0 490 484 the display is provided with two light shields, one being formed on the upper surface of the lower substrate and the other being formed on the lower surface of the upper substrate.

A first aspect of the present invention provides an optical scanning display as claimed in claim 1.

A second aspect of the second invention provides a method of manufacturing an optical scanning display as claimed in claim 7.

Preferred features of the present invention are set out in the dependent claims.

If an optical switching element has the shielding film of a-SiₓGe₁₋ₓ:H film provided on the surface of photoconductor opposite to the surface irradiated by light, undesirable light other than the necessary optical signal can be prevented from entering the photoconductor. If such optical switching elements are employed for those in an optical scanning display, a shielding layer as provided in an opposed substrate in a conventional display can be omitted.

Further objects and advantages of the present invention will be apparent from the following description of the preferred embodiments of the invention as illustrated in the accompanying drawings.

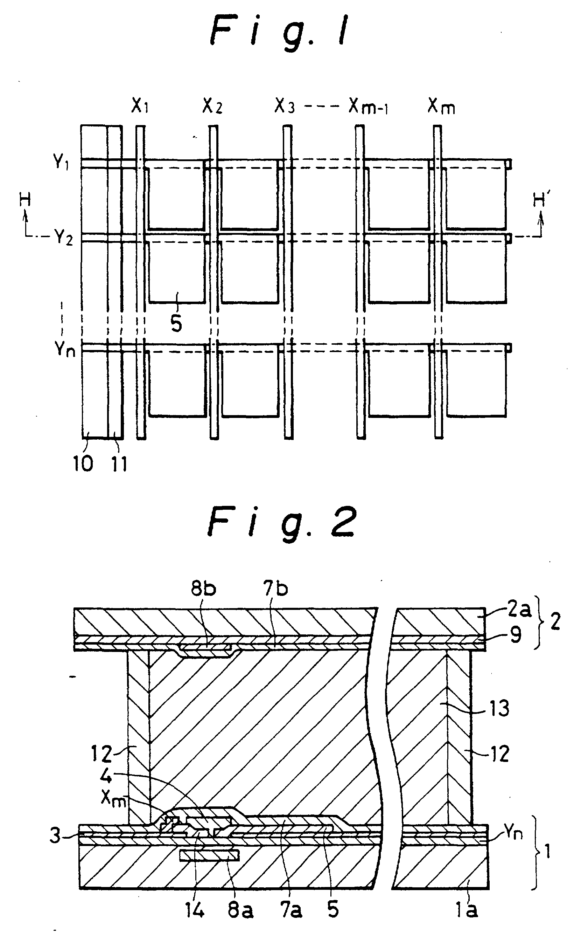

Fig. 1 is a plan view to show the structure of an optical scanning active-matrix liquid crystal display as described in Example 1 of the present application;
Fig. 2 is a cross sectional view to show the structure of an optical switching element as seen along H-H' line in Fig. 1;

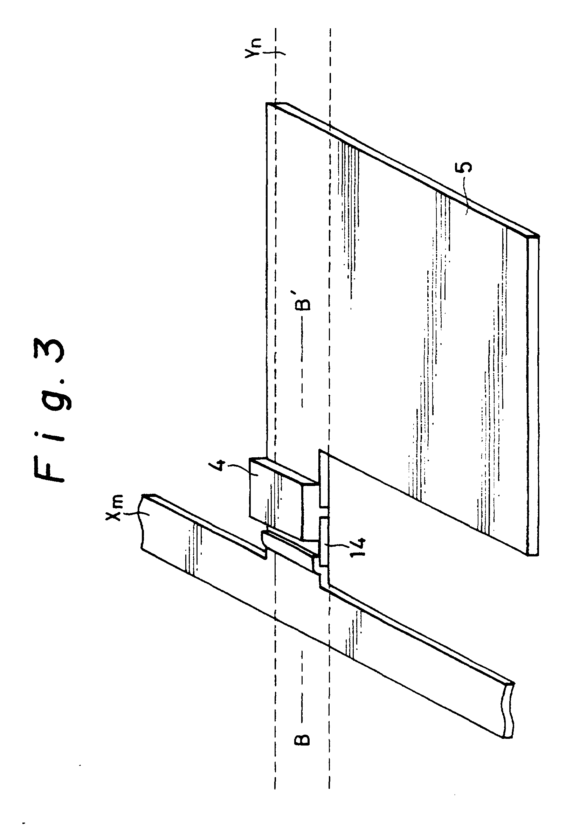

Fig. 3 is a perspective view to show an arrangement near an optical switching element in the display of Fig. 1;

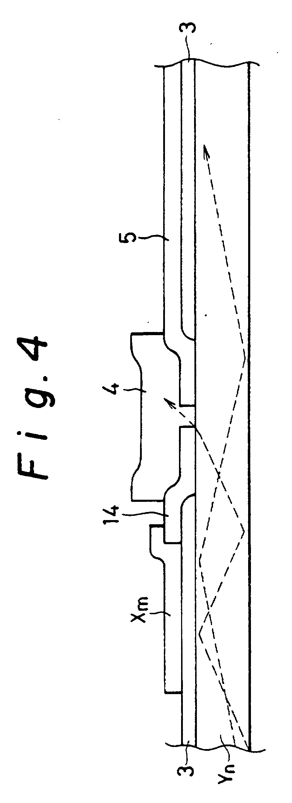

Fig. 4 is a cross sectional view to show the structure of an element as seen along B-B' line in Fig. 3;

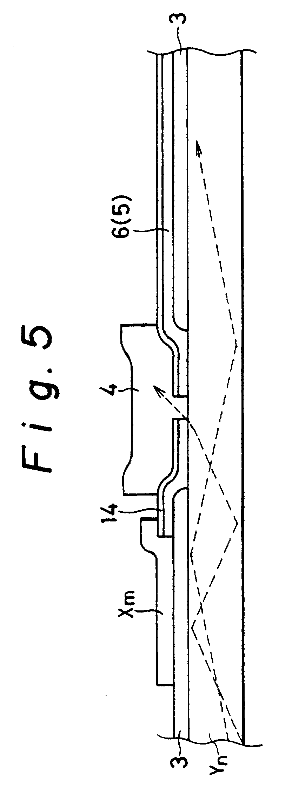

Fig. 5 is a cross sectional view to show the structure of an optical switching element as described in Example 2 of the present application;

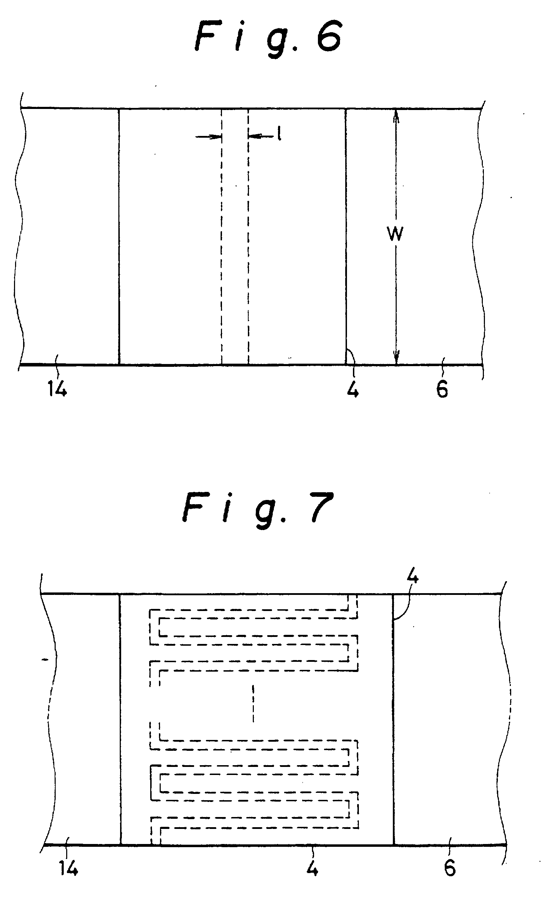

Fig. 6 is a drawing to show the shape of a source electrode and a drain electrode in the optical switching element as described in Example 1;
Fig. 7 is a drawing to show the shape of source electrode and drain electrode in the optical switching element as described in Example 3 of the present application;

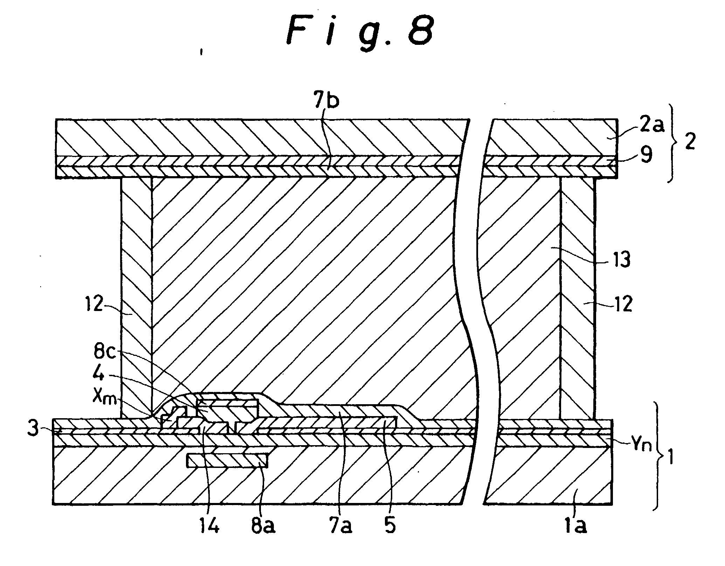

Fig. 8 is a drawing to show a cross section of an optical switching element and a display using it as described in Example 4;

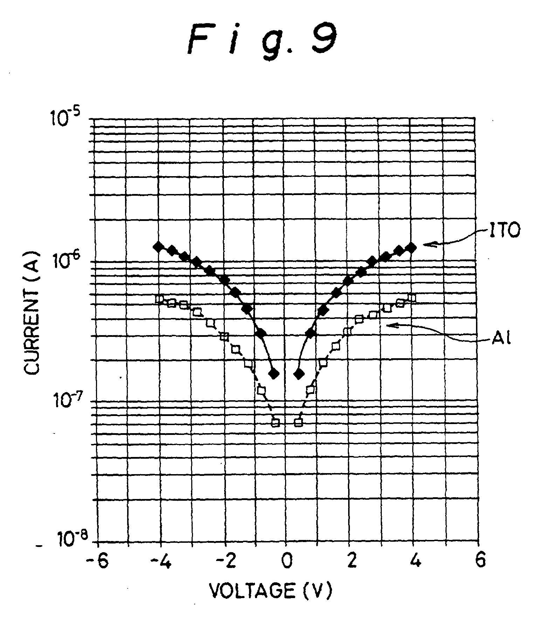

Fig. 9 is a drawing to show voltage-current characteristics of the optical switching element as described in Example 1;

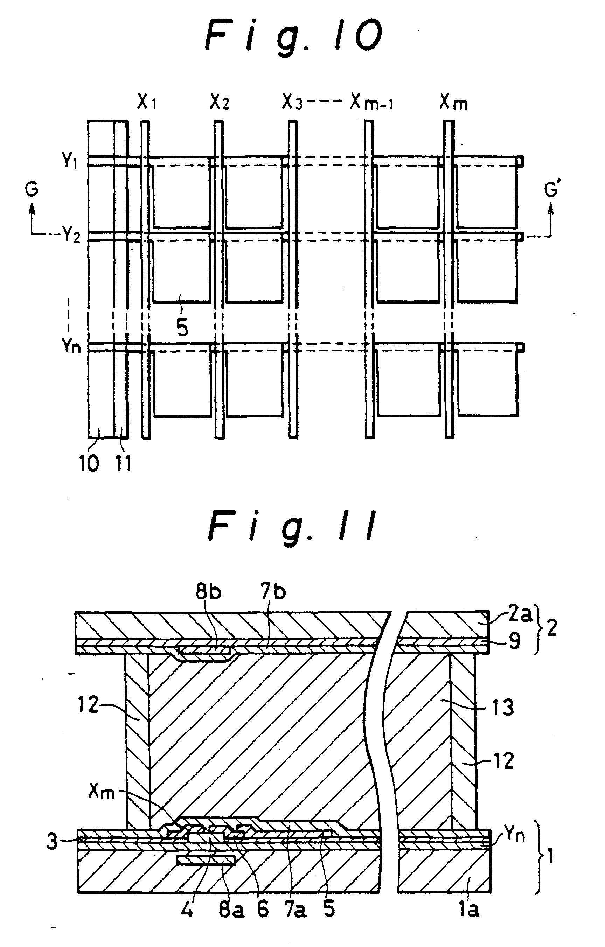

Fig. 10 is a plan view to show the structure of a conventional optical scanning active-matrix liquid crystal display;
Fig. 11 is a cross sectional view to show the structure of an element as seen along G-G' line in Fig. 10;
Fig. 12 is a schematic drawing to show a structure of optical switching element;
Fig. 13 is a schematic drawing to show another structure of optical switching element;
Fig. 14 is a schematic drawing to show another structure of optical switching element;
Fig. 15 is a perspective view to show an arrangement near an optical switching element in the display shown in Fig. 10; and
Fig. 16 is a cross sectional view to show the structure of an element as seen along B-B' line in Fig. 15.

Optical scanning displays according to the present invention will be described in detail with reference to the accompanying drawings.

### Example 1 (Comparative Example)

Fig. 1 is a plan view to show the structure of an optical scanning active-matrix liquid crystal display. The structure of an optical scanning device of the invention is generally similar, but incorporates the optical switching element described in Example 4 below. Fig. 2 is a cross sectional view to show the structure of an element as seen along H-H' line in Fig. 1.

A plurality of optical waveguides Y₁, Y₂,..., Yₙ are aligned in the Y direction on a glass substrate 1a, which is one of substrates constituting a liquid crystal panel. Also, a plurality of signal electrodes X₁, X₂,..., Xₘ are aligned in the X direction above the optical waveguides as intersecting therewith. The waveguides Y₁, Y₂,..., Yₙ may be optical fibers, ion-exchange (diffusion) waveguides, polymer waveguides or silica waveguides, for example.

The optical waveguides Y₁, Y₂,..., Yₙ are connected at their ends to a radiative unit composed of a light-emitting element array 10 and a micro lens array 11. The present embodiment employs a high-power LD (Laser Diode) array as the light-emitting element array 10. If a high power is not required, the light-emitting element array 10 may be a LED (Light Emitting Diode) array.

A SiO₂ film is formed as a clad layer 3 on the optical waveguides Y₁, Y₂,..., Yₙ.

Also, pixel electrodes 5 are formed on the clad layer. The pixel electrodes 5 are of a transparent and conductive ITO (Indium Tin Oxide) thin film, which is formed by sputtering.

The signal electrodes X₁, X₂,..., Xₘ are made of aluminum by sputtering. The signal electrodes X₁, X₂,..., Xₘ may be made of any other materials, for example tantalum, chromium. titanium, molybdenum, etc., as long as they satisfy the conditions of conductivity and process.

An amorphous hydrogenated silicon (a-Si:H) film with photoconductivity is formed as an optical switching element 4 by the plasma CVD (Chemical Vapor Deposition) method at each intersection between an optical waveguide Y₁, Y₂,..., Yₙ and a signal electrode X₁, X₂,..., Xₘ. The a-Si:H film is formed using silane (SiH₄) gas and hydrogen (H₂) gas, and its film thickness is in the range of about 5000 A to 1 µm. Each optical switching element 4 is set on between a signal electrode X₁, X₂,..., Xₘ and a pixel electrode 5 for driving a display medium such as a liquid crystal.

An ITO film is formed as a transparent electrode (opposed electrode) 9 by sputtering on another substrate 2a.

Polyimide 7a, 7b of orientation film is applied by spin coating onto the two substrates 1a, 2a and is subjected to an orientation treatment by rubbing thereafter. They are bonded to each other through spacers 12 and liquid crystal 13. Other orientation films may be employed as the orientation film, for example organic films such as polyamide, various LB (Langmuir-Blodgett) films, and orthorhombic vapor-deposited films of SiO or SiO₂.

The glass substrates 1a, 2a are provided with shielding layers 8a, 8b, respectively, for preventing light from the outside of the display from entering the optical switching elements 4. They are formed at positions overlapping with the pattern of optical switching elements 4.

The principle of operation is next described. An optical signal is guided from the light-emitting element array 10 through the micro lens array 11 to an optical waveguide Y₁, Y₂,..., Yₙ. The optical switching element 4 changes its impedance depending upon brightness of irradiating light, whereby a current flow between a signal electrode Xₘ and a pixel electrode 5 can be controlled so as to drive the liquid crystal.

In the light-irradiated state the optical switching element 4 has a low impedance by the photoconduction effect, so that the signal electrode Xₘ is electrically connected to the pixel electrode 5. As a result, a data signal is applied to the liquid crystal 13 present between the pixel electrode 5 and the opposed electrode 9. In a dark state the optical switching element 4 has a high impedance, so that the signal electrode Xₘ. is electrically insulated with respect to the pixel electrode 5. As a result, no data signal is applied between the pixel electrode 5 and the opposed electrode 9.

Since this display employs light as the scanning signal, it is free of influence of wiring resistance or stray capacitance, as compared with cases using an electric signal, and, therefore, causes no delay in signal waveform. Accordingly, a large-scale display or a high-precision display can be achieved.

Fig. 3 is a perspective view to show an arrangement near an optical switching element in the above display.

Also, Fig. 4 is a cross sectional view to show the structure of the element as seen along B-B' line in Fig. 3, showing the detailed construction of the source electrode and drain electrode. Here, a portion of pixel electrode 5 functions as a drain electrode, which is formed of a transparent ITO film. Also, the source electrode 14 is connected to a signal electrode Xₘ and formed of the transparent ITO film. As shown in Fig. 3, the present example employs the structure of Fig. 14 among the three types of element structures of optical switching element, and further employs a transparent electrode material for source electrodes and drain electrodes.

Accordingly, the electrodes (source and drain electrodes) are not located on steps present at edges of photoconductive material (a-Si:H in the present example), but are formed on a relatively flat substrate, which is unlikely to cause a disconnection trouble.

Also, since the electrodes are made of a transparent electrode material, a photoconductor portion located above the electrodes can be fully irradiated with an optical signal. Therefore, the light-irradiated area does not have to be increased even if the electrodes are located on the light irradiated side (on the side where more photoproduction carriers are produced), whereby an impedance change can be efficiently obtained between the electrodes with irradiation of optical signal.

Fig. 9 shows the results of measurements about voltage-current characteristics for optical switching elements with the structure as shown in Fig. 14, one of which has electrodes made of aluminum and the other of which has electrodes made of the ITO film, as irradiated by a laser beam of 1 mW/cm². The element with electrodes of ITO film is clearly improved in conductivity, which ensures that the optical switching element of Example 1 can efficiently achieve the impedance change between electrodes with light irradiation.

### Example 2 (Comparative Example)

In the optical switching element as described in Example 1 ITO was employed as the transparent electrode material for source electrodes and drain electrodes. Other transparent electrode materials applicable in the invention are materials as listed in the below table. The ITO is most suitable in respect of transparency and conductivity.

The optical switching element of this structure is formed in such a manner that the ITO film is first patterned by photolithography and then the a-Si:H film is formed thereon. When the a-Si:H film is formed on the ITO film, the a-Si:H film could be negatively affected by the ITO film, for example by the surface shape of ITO film or by decomposition (diffusion or composition change) of ITO film. For example, Inventors had such experiences as microscopic asperities appearing on the a-Si:H film or a change in conductivity depending upon conditions of film formation.

**TABLE**

| Type | Material |
|---|---|
| Metal | Au, Ag, Cu, Ni |
| | |
| Metal/Oxide | TiO₂/Ag/TiO₂, SnO₂/Ni/SnO₂, Bi₂O₃/Au/Bi₂O₃, Pt/SnO₂, SnO₂/Au/SnO₂ |
| | |
| Oxide | SnO₂, In₂O₃, CdO, ZnO, TiO, SnO₂-Sb, SnO₂-WO₃, In₂O₃-SnO₂, In₂O₃-Sb₂O₃, In₂O₃-WO₃, SnO₂-F, In₂O₃-Al |
| | |
| Non Oxide | LaB₄, TiN, CdS |

In the above table, A/B means a laminate film of A and B, and A-B a mixture of A and B.

A second example describes an optical switching element constructed such that a buffer layer made of tin oxide (SnO₂) is provided in an interface between the ITO film and the a-Si:H film in order to stably form the a-Si:H film upon production of optical switching element.

Fig. 5 is a cross sectional view to show an optical switching element in Example 2. Fig. 5 corresponds to Fig. 4 showing the cross section of the optical switching element as described in Example 1.

A source electrode 14 and a drain electrode 6 (pixel electrode 5) each are constructed as a laminate film of SnO₂/ITO. The film thickness of SnO₂ film is set to 200 angstroms, and that of ITO film to 800 angstroms. The ITO film can be patterned by wet etching using an acid solution such as hydrogen bromide (HBr) similarly as in the conventional cases, but the SnO₂ film cannot be etched thereby because it is chemically very stable. In the present example, the SnO₂ film was patterned by the lift-off process accordingly. In the lift-off process, a photoresist is first applied over a substrate and then patterned, and thereafter a SnO₂ film is formed. The SnO₂ film formed on the resist is removed together with the resist when the resist is taken away. The SnO₂ film is left without being removed where no resist exists. On this occasion, employing the method in which the resist thin film is double-layered at a pre-stage of the lift-off process as described in "VLSI Technology", P. 298 (OHM SHA, Author: Tarui), the lift-off process can be stabilized, enabling micromachining of submicron order.

The above-described optical switching element has a lamination structure of a-Si:H/SnO₂/ITO in the source electrode and drain electrode portions. Since the SnO₂ film prevents the negative influence of ITO film, such as the surface shape or decomposition, on the a-Si:H film, an excellent a-Si:H film can be readily obtained. Accordingly, this arrangement is very advantageous in respect of process upon producing an optical switching element or an optical scanning display using it.

### Example 3 (Comparative Example)

When an optical switching element is irradiated by an optical signal for scan in an optical scanning display, the impedance thereof is lowered so as to electrically connect a source electrode with a drain electrode. Thus, a signal electrode is connected with a pixel electrode, whereby a electrooptical medium (for example liquid crystal) is charged. If a decrease in impedance of optical switching element is not sufficient in this case, the charge of electrooptical medium could be insufficient. Particularly, a problem occurs with picture elements having a large capacitance (which is a capacitance formed by the electrooptical medium between the pixel electrode 5 and the opposed electrode 9).

There is a method for adjusting the size of optical switching element itself in order to increase the ON-state current of optical switching element.

Fig. 6 shows the shape of the source electrode 14 and the drain electrode 6 in the optical switching element as described in Example 1. Namely, it is a top plan view of the optical switching element shown in Fig. 4.

In Fig. 6, a further decrease in electrode gap 1 or a further increase in electrode width w can decrease the resistance between the electrodes, whereby the ON-state current can be increased. However, the present electrode gap 1 is in the range of 2 to 4 µm and therefore a further decrease thereof requires a high-level photolithography technology, which is not preferable. Also, a further increase in electrode width w would decrease the aperture rate of display, which is not preferable, either.

Therefore, the following method is preferable to increase the ON-state current.

Fig. 7 is a drawing to show the shape of electrodes in an optical switching element in the present example.

A source electrode 14 and a drain electrode 6 are shaped in an interdigital pattern as meshing with each other. This arrangement effectively increases the electrode width w without changing the occupying area of optical switching element, i.e., without decreasing the aperture rate of display.

As described, the display shown in the present example employs the interdigital electrode structure as well as the structure of optical switching element as described in Example 1, whereby the ON-state current can be increased. Therefore, a display further improved in performance can be provided.

### Example 4

The conventional display as shown in Fig. 11 is provided with the shielding films 8a, 8b to prevent external light from irradiating the optical switching element 4. In this arrangement, the shielding film 8b formed on the opposed substrate 2 side must be formed at a distance the thickness of cell away from the optical switching element 4. In that case, the shielding film 8b must be formed in a considerably large size as compared with the size of optical switching element in order to improve the shielding effect. The shielding film 8b significantly reduces the aperture ratio of the display.

In the structure of optical switching element as described in Example 1 of the present application the photoconductor made of the a-Si:H film is formed on the transparent conductive film (electrodes) such as ITO. The shielding film can be thus freely formed on the photoconductor.

Fig. 8 is a drawing to show a cross section of an optical switching element in which a shielding film is formed right on the photoconductor, and a display using it.

The shielding film 8c is an a-SiₓGe₁₋ₓ:H film formed by the plasma CVD method. The a-SiₓGe₁₋ₓ:H film can be attained with sufficient light shielding property against visible light, and with high resistance and poor photoconductivity by adjusting the composition of Si and Ge. For example, when mono-silane and germane are mixed at a proper gas flow ratio in film formation, a resultant film has a poor photoconductivity with absorption coefficient of at least 10⁴ (wavelength 633 nm) and dark conductivity of 10⁻⁷ [1/Ωcm], which is suitable for the shielding film.

As described above, using the optical switching element shown in the present embodiment, the shielding film 8c provided on the photoconductor can replace the shielding film 8b which has been provided on the opposed substrate side in the conventional elements.

A display using the above optical switching element can greatly improve the aperture rate accordingly.

Also, the a-SiₓGe₁₋ₓ:H film is used as the shielding film 8c. Thus, if the photoconductor is a film made of a Si-base material such as the a-Si:H film and formed by the plasma CVD method, the photoconductor and the shielding film 8c can be continuously formed in a same apparatus, which is advantageous in respect of process. Although the present embodiment showed an example utilizing a compound of silicon and germanium, it is not limited to the compound. The shielding film can be made of another silicon compound, for example a compound of silicon and tin or a compound of silicon and germanium and carbide.

The optical switching elements as described in Examples 1 to 4 may be constructed in the diode structure of semiconductor having the photoconductivity (for example, of the pin type, the Schottky type, or the MIS [Metal-Insulator-Semiconductor] type), in the back-to-back diode structure in which such two diodes are inversely connected in series, or in the diode ring structure in which such two diodes are inversely connected in parallel.

Also, the TN (Twisted Nematic) mode is employed for the liquid crystal layer used in the displays of the present invention. The liquid crystal material is a fluorine-base liquid crystal ZLI 4792 supplied by MERCK. Other applicable modes using the nematic liquid crystal are the guest-host mode, the birefringence control (ECB: Electrically Controlled Birefringence) mode, the STN (Super Twisted Nematic) mode and the phase transition mode. Further applicable are the surface stabilized ferroelectric liquid crystal (SSFL) mode using a chiral smectic liquid crystal, the polymer composite liquid crystal (PDLC: Polymer Dispersed Liquid Crystal) using a composite film of polymer and liquid crystal, etc.

Further, the present invention was described about the liquid crystal display (LCD) using the liquid crystal as electrooptical medium, but the present invention can be applied with the same effect to other displays, for example electrochromic displays (ECD) and electrophoretic displays (EPD).

The optical switching elements of the present invention will rarely have a disconnection trouble, because the electrodes (source and drain electrodes) employed are formed on a relatively flat substrate. Also, since the electrodes are made of a transparent electrode material, the photoconductor portion located above the electrodes can be fully irradiated by an optical signal, whereby an impedance change can be efficiently achieved between the electrodes with irradiation of optical signal.

Also, the source electrode and drain electrode portion is constructed in the laminate structure of a-Si:H/SnO₂/ITO, which can prevent the negative influence of ITO film on the a-Si:H film, such as the surface shape or decomposition of ITO film. Thus, an excellent a-Si:H film can be readily obtained.

In case the source electrode and drain electrode each are shaped in a zigzag pattern as meshing with each other, the ON-state current can be increased without lowering the aperture rate of display.

Also, in case a shielding film is provided on the optical switching element itself, a display using it can obviate a part of shielding film, improving the aperture rate.

Many widely different embodiments of the present invention may be constructed without departing from the scope of the present invention. It should be understood that the present invention is not limited to the specific embodiments described in the specification, but is defined in the appended claims.

## Claims

1. An optical scanning display comprising:
a first substrate (1a);
a plurality of optical waveguides (Yₙ) disposed on said first substrate to provide optical paths for an optical signal;
a plurality of signal electrodes (Xₘ) provided on said first substrate, the signal electrodes being perpendicular to the waveguides;
a plurality of pixel electrodes (5) disposed on the first substrate, one pixel electrode being provided for each intersection between a signal electrode and a waveguide;
a second substrate (2a) having a common electrode (9) thereon;
an electro-optical medium (13) provided between said first and second substrates and driven by a voltage applied between one of the pixel electrodes and the common electrode;
a plurality of optical switching elements provided on said first substrate, one optical switching element being provided for each pixel electrode, each optical switching element comprising: a photoconductor (4) whose impedance changes when irradiated by light; a transparent source electrode provided under said photoconductor and being in contact with one of the signal electrodes (Xₘ); a transparent drain electrode provided under said photoconductor and being in contact with the associated pixel electrode, the photoconductor electrically connecting the source electrode and the drain electrode when the photoconductor is irradiated; and a shielding film (8c) provided on an opposite surface of said photoconductor from the surface of said photoconductor illuminated by light from the corresponding waveguide the shielding film having a high resistance and low photoconductivity ;
each optical switching element electrically connecting the corresponding source electrode and the corresponding drain electrode when the photoconductor of the switching element is illuminated by an optical signal through the corresponding waveguide;
**characterised in that** the shielding film of an optical switching element is disposed directly on the photoconductor of the optical switching element.

2. A display according to claim 1, wherein said shielding film is made of a compound of silicon and germanium.

3. A display according to claim 2, wherein said compound of silicon and germanium is an amorphous hydrogenated silicon germanium (a-SiₓGe₁₋ₓ:H).

4. A display according to claim 1, wherein said shielding film is made of a compound of silicon and tin.

5. A display according to claim 1, wherein said transparent drain electrode is a portion of one of said pixel electrodes.

6. A display according to claim 1 wherein the photoconductor is made of amorphous hydrogenated silicon (a-Si:H), and wherein the shielding film is made of a compound of silicon and germanium, a compound of silicon and tin, or a compound of silicon, germanium and carbide.

7. A method of manufacturing an optical scanning display, the display comprising:
a first substrate (1a);
a plurality of optical waveguides (Yₙ) disposed on said first substrate to provide optical paths for an optical signal;
a plurality of signal electrodes (Xₘ) provided on said first substrate, the signal electrodes being perpendicular to the waveguides;
a plurality of pixel electrodes (5) disposed on the first substrate, one pixel electrode being provided for each intersection between a signal electrode and a waveguide;
a second substrate (2a) having a common electrode (9) thereon;
an electro-optical medium (13) provided between said first and second substrates and driven by a voltage applied between one of the pixel electrodes and the common electrode;
a plurality of optical switching elements provided on said first substrate, one optical switching element being provided for each pixel electrode, each optical switching element comprising: a photoconductor (4) whose impedance changes when irradiated by light; a transparent source electrode provided under said photoconductor and being in contact with one of the signal electrodes (Xₘ); a transparent drain electrode provided under said photoconductor and being in contact with the associated pixel electrode, the photoconductor electrically connecting the source electrode and the drain electrode when the photoconductor is irradiated and a shielding film (8c) provided on an opposite surface of said photoconductor from the surface of said photoconductor illuminated by light from the corresponding waveguide, the shielding film having a high resistance and low photoconductivity;
each optical switching element electrically connecting the corresponding source electrode and the corresponding drain electrode when the photoconductor of the switching element is illuminated by an optical signal through the corresponding waveguide;
the method being **characterised in that** shielding film of an optical switching element and the photoconductor of the optical switching element are formed in one continuous process by a plasma CVD method whereby the shielding film of an optical switching element is disposed directly on the photoconductor of the optical switching element.

8. A method according to claim 7 wherein the photoconductor is made of amorphous hydrogenated silicon (a-Si:H), and wherein the shielding film is made of a compound of silicon and germanium, a compound of silicon and tin, or a compound of silicon, germanium and carbide.

## Patentansprüche

1. Optisch adresssierbare Anzeige mit:
einem ersten Substrat (1a);
einer Mehrzahl auf dem ersten Substrat verteilter optischer Wellenleiter (Yₙ), um optische Wege für ein optisches Signal bereitzustellen;
einer Mehrzahl von senkrecht zu den Wellenleitern angeordneten Signalelektroden (Xₘ);
einer Mehrzahl auf dem Substrat verteilter Pixelelektroden (5), wobei eine Pixelelektrode für jeden Schnittpunkt zwischen einer Signalelektrode und einem Wellenleiter vorgesehen ist;
einem zweiten Substrat (2a) mit einer gemeinsamen Elektrode;
einem zwischen dem ersten und dem zweiten Substrat vorhandenen elektro-optischen Medium (13), welches von einer Spannung zwischen einer der Pixelelektrode und der Common-Elektrode beaufschlagt ist;
einer Mehrzahl auf dem ersten Substrat angeordneter optischer Schaltelemente, jeweils eines für eine Pixelelektrode, wobei jedes optische Schaltelement einen Fotoleiter (4), dessen Impedanz sich bei Lichteinstrahlung ändert, eine unter dem Fotoleiter angebrachte transparente Source-Elektrode in Kontakt mit einer der Signalelektroden (Xₘ) und eine transparente unter dem Fotoleiter angebrachte Drain-Elektrode in Kontakt mit der zugeordneten Pixelelektrode aufweist, wobei der Fotoleiter Source- und Drain-Elektrode elektrisch verbindet, wenn der Fotoleiter bestrahlt wird; und
einem Abschirmfilm (8c) mit hohem Widerstand und geringer Fotoleitfähigkeit auf der Rückseite des Fotoleiters, die derjenigen Fotoleiterfläche entgegengesetzt liegt, die vom Licht des zugeordneten Wellenleiters bestrahlt ist, wobei
jedes optische Schaltelement die entsprechende Source-Elektrode mit der entsprechenden Drain-Elektrode elektrisch verbindet, wenn der Fotoleiter des Schaltelements durch ein optisches Signal des entsprechenden Wellenleiters bestrahlt ist;
**dadurch gekennzeichnet, dass** der Abschirmfilm eines optischen Schaltelements direkt auf den Fotoleiter des Schaltelements aufgebracht ist.

2. Anzeige nach Anspruch 1, in welcher der Abschirmfilm aus einer Verbindung von Silizium und Germanium hergestellt ist.

3. Anzeige nach Anspruch 2, in welcher die Silizium-Germanium-Verbindung ein amorphes Silizium-Germanium-Hydrid (a-Siₓ GEₓ₋₁:H) ist.

4. Anzeige nach Anspruch 1, in welcher der Abschirmfilm aus einer Verbindung von Silizium und Zinn hergestellt ist.

5. Anzeige nach Anspruch 1, in welcher die transparente Drain-Elektrode ein Teil der Pixelelektrode ist.

6. Anzeige nach Anspruch 1, in welcher der Fotoleiter aus einem amorphen Siliziumhydrid (a-Si:H) und der Abschirmfilm aus einer Verbindung aus Silizium und Germanium, einer Verbindung von Silizium und Zinn oder einer Verbindung aus Silizium, Germanium und Carbid hergestellt sind.

7. Verfahren zur Herstellung einer optisch adressierbaren Anzeige mit:
einem ersten Substrat (1a);
einer Mehrzahl auf dem ersten Substat verteilter optischer Wellenleiter (Yₙ), um optische Wege für ein optisches Signal zu bereitzustellen;
einer Mehrzahl von senkrecht zu den Wellenleitern auf dem ersten Substrat angeordneten Signalelektroden (Xₘ);
einer Mehrzahl auf dem ersten Substrat verteilter Pixelelelektroden (5), wobei eine Pixelelektrode für jeden Schnittpunkt zwischen einer Signalelektrode und einem Wellenleiter vorgesehen ist;
einem zweiten Substrat (2a) mit einer gemeinsamen Elektrode;
einem zwischen dem ersten und dem zweiten Substrat vorhandenem elektro-optischen Medium (13), welches von einer Spannung zwischen einer der Pixelelektroden und der Common-Elektrode beaufschlagt ist;
einer Mehrzahl auf dem ersten Substrat angeordneter optischer Schaltelemente, jeweils eines für eine Pixelelektrode, wobei jedes optische Schaltelement einen Fotoleiter (4), dessen Impedanz sich bei Lichteinstrahlung ändert, eine unter dem Fotoleiter angebrachte transparente Source-Elektrode in Kontakt mit einer der Signalelektroden (Xₘ), eine transparente unter dem Fotoleiter angebrachte Drain-Elektrode in Kontakt mit der zugeordneten Pixelelektrode aufweist, wobei der Fotoleiter Source- und Drain-Elektrode elektrisch verbindet, wenn der Fotoleiter bestrahlt wird; und
einem Abschirmfilm (8c) mit hohem Widerstand und geringer Fotoleitfähigkeit auf der Rückseite des Fotoleiters, die derjenigen Fotoleiterfläche entgegengesetzt liegt, die vom Licht des zugeordneten Wellenleiters bestrahlt wird, wobei
jedes optische Schaltelement die entsprechende Source-Elektrode mit der entsprechenden Drain-Elektrode elektrisch verbindet, wenn der Fotoleiter des Schaltelements durch ein optisches Signal des entsprechenden Wellenleiters bestrahlt wird;
Verfahren, **dadurch gekennzeichnet, dass** der Abschirmfilm eines optischen Schaltelements und der Fotoleiter des optischen Schaltelements in einem kontinuierlichen Plasma-CVD-Verfahren hergestellt werden, wobei der Abschirmfilm eines optischen Schaltelements direkt auf dem optischen Schaltelement abgeschieden wird.

8. Verfahren nach Anspruch 7, in welchem der Fotoleiter aus amorphem Siliziumhydrid (a-Si:H) und der Abschirmfilm aus einer Verbindung von Silizium und Germanium, einer Verbindung von Silizium und Zinn oder einer Verbindung aus Silizium. Germanium und Carbid hergestellt werden.

## Revendications

1. Un dispositif de visualisation à balayage optique comprenant:
un premier substrat (1a);
une multiplicité de guides d'ondes optiques (Yₙ) disposés sur le premier substrat pour établir des chemins optiques pour un signal optique;
une multiplicité d'électrodes de signal (Xₘ) formées sur le premier substrat, les électrodes de signal étant perpendiculaires aux guides d'ondes;
une multiplicité d'électrodes de pixel (5) disposées sur le premier substrat, une électrode de pixel étant incorporée pour chaque intersection entre une électrode de signal et un guide d'ondes;
un second substrat (2a) sur lequel se trouve une électrode commune (9);
un milieu électro-optique (13) placé entre les premier et second substrats et excité par une tension appliquée entre l'une des électrodes de pixel et l'électrode commune;
une multiplicité d'éléments de commutation optiques placés sur le premier substrat, un élément de commutation optique étant incorporé pour chaque électrode de pixel, chaque élément de commutation optique comprenant: un photoconducteur (4) dont l'impédance change lorsqu'il est irradié par de la lumière; une électrode de source transparente placée sous le photoconducteur et étant en contact avec l'une des électrodes de signal (Xₘ); une électrode de drain transparente placée sous le photoconducteur et étant en contact avec l'électrode de pixel associée, le photoconducteur connectant électriquement l'électrode de source et l'électrode de drain lorsque le photoconducteur est irradié; et une pellicule de blindage (8c) placée sur une surface opposée du photoconducteur par rapport à la surface du photoconducteur illuminée par la lumière provenant du guide d'ondes correspondant, la pellicule de blindage ayant une résistance élevée et une faible photoconductivité;
chaque élément de commutation optique connectant électriquement l'électrode de source correspondante et l'électrode de drain correspondante lorsque le photoconducteur de l'élément de commutation est illuminé par un signal optique transmis par le guide d'ondes correspondant;
**caractérisé en ce que** la pellicule de blindage d'un élément de commutation optique est directement disposée sur le photoconducteur de l'élément de commutation optique.

2. Un dispositif de visualisation selon la revendication 1, dans lequel la pellicule de blindage est constituée par un composé de silicium et de germanium.

3. Un dispositif de visualisation selon la revendication 2, dans lequel le composé de silicium et de germanium consiste en silicium-germanium amorphe hydrogéné (a-SiₓGe₁₋ₓ:H).

4. Un dispositif de visualisation selon la revendication 1, dans lequel la pellicule de blindage est constituée d'un composé de silicium et d'étain.

5. Un dispositif de visualisation selon la revendication 1, dans lequel l'électrode de drain transparente est une partie de l'une des électrodes de pixel.

6. Un dispositif de visualisation selon la revendication 1, dans lequel le photoconducteur consiste en silicium amorphe hydrogéné (a-Si:H), et dans lequel la pellicule de blindage est constituée d'un composé de silicium et de germanium, d'un composé de silicium et d'étain, ou d'un composé de silicium, de germanium et de carbure.

7. Un procédé de fabrication d'un dispositif de visualisation à balayage optique, le dispositif de visualisation comprenant:
un premier substrat (1a);
une multiplicité de guides d'ondes optiques (Yₙ) disposés sur le premier substrat pour établir des chemins optiques pour un signal optique;
une multiplicité d'électrodes de signal (Xₘ) incorporées sur le premier substrat, les électrodes de signal étant perpendiculaires aux guides d'ondes;
une multiplicité d'électrodes de pixel (5) disposées sur le premier substrat, une électrode de pixel étant incorporée pour chaque intersection entre une électrode de signal et un guide d'ondes;
un second substrat (2a) portant une électrode commune (9);
un milieu électro-optique (13) placé entre les premier et second substrats et excité par une tension appliquée entre l'une des électrodes de pixel et l'électrode commune;
une multiplicité d'éléments de commutation optiques placés sur le premier substrat, un élément de commutation optique étant incorporé pour chaque électrode de pixel, chaque élément de commutation optique comprenant: un photoconducteur (4) dont l'impédance change lorsqu'il est irradié par de la lumière; une électrode de source transparente placée sous le photoconducteur et étant en contact avec l'une des électrodes de signal (Xₘ); une électrode de drain transparente placée sous le photoconducteur et étant en contact avec l'électrode de pixel associée, le photoconducteur connectant. électriquement l'électrode de source et l'électrode de drain lorsque le photoconducteur est irradié, et une pellicule de blindage (8c) placée sur une surface opposée du photoconducteur par rapport à la surface du photoconducteur illuminée par la lumière provenant du guide d'ondes correspondant, la pellicule de blindage ayant une résistance élevée et une faible photoconductivité,
chaque élément de commutation optique étant connecté électriquement à l'électrode de source correspondante et à l'électrode de drain correspondante lorsque le photoconducteur de l'élément de commutation est illuminé par un signal optique à travers le guide d'ondes correspondant;
le procédé étant **caractérisé en ce que** la pellicule de blindage d'un élément de commutation optique et le photoconducteur de l'élément de commutation optique sont formés en un seul processus continu par un procédé de dépôt chimique en phase vapeur par plasma, grâce à quoi la pellicule de blindage d'un élément de commutation optique est disposée directement sur le photoconducteur de l'élément de commutation optique.

8. Un procédé selon la revendication 7, dans lequel le photoconducteur consiste en silicium amorphe hydrogéné (a-Si:H), et dans lequel la pellicule de blindage consiste en un composé de silicium et de germanium, un composé de silicium et d'étain, ou un composé de silicium, de germanium et de carbure.
